# EUROPÄISCHE PATENTSCHRIFT

(11) **EP 3 997 971 B1**
(45) Veröffentlichungstag und Bekanntmachung des Hinweises auf die Patenterteilung: **28.02.2024**
(21) Anmeldenummer: 20733183.6
(22) Anmeldetag: 23.06.2020
(51) Int. Cl.: H05K 7/20, H05K 7/14

(54) **STEUERSCHRANK UND ZUGEHÖRIGES EINSCHUB-STEUERGERÄT**
CONTROL CABINET AND ASSOCIATED INSERTABLE CONTROL DEVICE
ARMOIRE DE COMMANDE ET APPAREIL DE COMMANDE D'INSERTION ASSOCIÉ

(30) Priorität: 08.07.2019 DE 202019103733 U
(43) Veröffentlichungstag der Anmeldung: 18.05.2022
(73) Patentinhaber: KUKA Deutschland GmbH, 86165 Augsburg (DE)
(72) Erfinder: STEIDL, Dietmar, 86163 Augsburg (DE)
(74) Vertreter: Oelke, Jochen
(86) Internationale Anmeldenummer: PCT/EP2020/067441
(87) Internationale Veröffentlichungsnummer: WO 2021/004775

(56) Entgegenhaltungen:
- DE-A1- 3 316 978
- DE-A1-102011 005 838

## Beschreibung

Die Erfindung betrifft einen Steuerschrank für wenigstens eine elektrische Antriebssteuerung. Die Erfindung betrifft außerdem ein zugehöriges Einschub-Steuergerät.

Aus der EP 2 797 396 A2 ist ein Steuerschrank insbesondere eines Industrieroboters bekannt, aufweisend ein Gehäuse, wenigstens eine innerhalb des Gehäuses angeordnete elektrische und/oder elektronische Komponente, und einen elektromechanischen Energiespeicher, der einen elektrischen Motor und ein drehbar gelagertes Schwungrad aufweist, das mittels des elektrischen Motors in Drehung versetzbar und eingerichtet ist, einen Luftstrom zum Kühlen der wenigstens einen elektrischen und/oder elektronischen Komponente zu erzeugen.

Aus der WO 2018/138041 A1 ist eine Kühlvorrichtung zum Kühlen von elektrischen Komponenten einer Robotersteuervorrichtung mittels einer durch einen Lüfter erzeugten Kühlluftströmung bekannt, aufweisend einen ersten Aufnahmeraum für erste elektrische Komponenten, einen zweiten Aufnahmeraum für zweite elektrische Komponenten und eine den ersten Aufnahmeraum strömungstechnisch von dem zweiten Aufnahmeraum separierende Kühlkörperwand, welche eine dem ersten Aufnahmeraum zugewandte erste Trennwandoberfläche und eine gegenüberliegende, einem Zwischenraum der Kühlkörperwand zugewandte zweite Trennwandoberfläche aufweist, die mit wenigstens einen Strömungskanal bildenden Kühlwandvorsprüngen versehen ist, und welche Kühlkörperwand eine Kühlluft-Durchtrittsöffnung aufweist, die ausgebildet ist, einen von wenigstens einem Lüfter der Kühlvorrichtung geförderten Kühlluftstrom aus dem ersten Aufnahmeraum durch die Kühlkörperwand hindurch in den Zwischenraum zu fördern.

Aus der DE 10 2011 005838 A1 ist eine Vorrichtung zum aktiven Belüften von Einbauten eines Einschubs eines Schaltschranks offenbart die einen Einschub umfasst und einen Schaltschrank mit Fachtrennwänden, die mindestens ein Fach zur Aufnahme des Einschubs bilden, wobei der Einschub ein Lüftergehäuse mit mindestens einem Lüfter umfasst, wobei eine der Fachtrennwände einen Lüfterschacht mit einer Öffnung umfasst.

Aus der DE 33 16 978 A1 ist ein Aufbausystem zur Entwärmung von in Behältern oder Schränken angeordneten elektronischen Baugruppen gezeigt, die Baugruppenträger gelagert werden. Diese kastenförmigen Träger weisen an ihren Rückseiten Einlassöffnungen und an ihren Frontseiten Auslassschlitze für den Kühlluftstrom auf.

Aufgabe der Erfindung ist es, einen Steuerschrank zu schaffen, der eine verbesserte Kühlwirkung für in den Steuerschrank eingesetzte Einschub-Steuergeräte aufweist. Eine weitere Aufgabe ist es, ein Einschub-Steuergerät mit zuverlässiger Kühlwirkung zu schaffen, das in solche Steuerschränke einfach und schnell eingesetzt werden kann.

Diese Aufgabe wird erfindungsgemäß gelöst durch einen Steuerschrank nach Anspruch 1 für wenigstens eine elektrische Antriebssteuerung, aufweisend:
ein Steuerschrankgehäuse,
ein im Steuerschrankgehäuse ausgebildetes erstes Schrankabteil, das wenigstens eine Eintrittsöffnung für Frischluft, wenigstens eine erste Übertrittsöffnung und einen die wenigstens eine Eintrittsöffnung mit der wenigstens einen ersten Übertrittsöffnung strömungstechnisch verbindenden Frischluftkanal aufweist,
ein im Steuerschrankgehäuse ausgebildetes zweites Schrankabteil, das wenigstens eine Austrittsöffnung für Abluft, wenigstens eine zweite Übertrittsöffnung und einen die wenigstens eine Austrittsöffnung mit der wenigstens einen zweiten Übertrittsöffnung strömungstechnisch verbindenden Abluftkanal aufweist, sowie
ein im Steuerschrankgehäuse ausgebildetes drittes Schrankabteil, das strömungstechnisch sowohl gegen das erste Schrankabteil, das zweite Schrankabteil und die Umgebung außerhalb des Steuerschrankes abgedichtet ist, wobei
das Steuerschrankgehäuse eine das dritte Schrankabteil gegen das erste Schrankabteil und das zweite Schrankabteil strömungstechnisch abgrenzende Trennwand aufweist, welche die wenigstens eine erste Übertrittsöffnung und die wenigstens eine zweite Übertrittsöffnung aufweist, und das dritte Schrankabteil als ein Rack mit wenigstens einem Schubfach ausgebildet ist, wobei jedes Schubfach zur Aufnahme eines Einschub-Steuergerätes ausgebildet ist.

In der Antriebstechnik und im Speziellen auch in der Robotik werden Frequenzumrichter verwendet um Motoren, z.B. permanent erregte Synchronmaschinen, zu betreiben. Zur Erreichung einer geeigneten Schutzart (IP) werden Frequenzumrichter üblicherweise zusammen mit der Steuerung in einen Steuerschrank eingebaut. Bei größeren Manipulatoren bzw. Industrierobotern entstehen in den Frequenzumrichtern größere thermische Verluste, die in geeigneter Weise aus dem Steuerschrank herausgeleitet werden müssen.

Da Wärmetauscher bei der abzuführenden Wärme recht groß ausfallen würden und außerdem zu einer höheren Temperatur im Frequenzumrichter führen könnten, werden Frequenzumrichter üblicherweise in einer "Durchsteck-Technik" in Steuerschränke eingebaut. Hierbei benötigt der Steuerschrank allerdings eine Rückwand mit passend ausgeschnittenen Durchbrüchen. Durch diese hängen dann die Frequenzumrichter mit ihren Kühlkörpern in einen Außen-Kühlluftkanal um die Wärme direkt nach außen zu leiten.

Diese Anordnung ist zwar technisch einfach zu realisieren, weist aber mehrere Nachteile auf. Da die Kühlkörper bei höheren Motorströmen und/oder Leistungen eine große Grundfläche benötigen, müssen die Frequenzumrichter i.a. hochkant an die Rückwand geschraubt werden. Durch das große Gewicht und den Einbau weit hinten im Schrank ist ein Tausch aus ergonomischen Gesichtspunkten schwierig. Die Kühlluft wird aufgrund der natürlichen Konvektion normalerweise von unten nach oben durch den Kühlkörper geblasen. Frequenzumrichter, die weiter oben im Schrank montiert werden, erhalten also bereits vorgewärmte Luft von weiter unten sitzenden Frequenzumrichtern und können nicht mehr gut entwärmt werden. Der vertikale Einbau führt bei Multiroboter-Steuerschränken schnell zu sehr hohen und weniger tiefen Schränken. Dadurch erhöht sich die Kippgefahr des Steuerschrankes deutlich.

Mit der Erfindung können gegebenenfalls, einzeln oder in Kombination, folgende Verbesserungen erzielt werden:
Eine einfach, schnell und ergonomisch tauschbare Steuerung (Einschub-Steuergerät) um die Einrichtungszeiten klein zu halten. Es kann sich ein kompakter und platzsparender Aufbau und ein skalierbares System ergeben. Es kann ein deutlich vereinfachter Einbau realisiert werden.

Zur Lösung der Aufgabe soll ein Rack-basierter Schrank dienen, der eine Anzahl an Einschubfächern besitzt. In jedes der Einschubfächer kann z.B. ein Steuerungsmodul (d.h. Einschub-Steuergerät) mit integriertem Frequenzumrichter einfach und ergonomisch horizontal liegend eingeschoben und mechanisch fixiert werden. Das Steuerungsmodul hat einen innenliegenden Kühlkörper, wahlweise oben, mittig oder unten, mit geregeltem Ventilator und wird mechanisch an passende Dichtlippen in der Seitenwand des Schrankes angepresst, wobei der Lufteinlass des Moduls kalte Luft durch eine Öffnung aus dem FrischluftKanal ansaugt, durch den U-förmigen Kühlkörper drückt und schließlich heiß durch eine zweite Öffnung in den Abluftkanal abbläst.

Durch die Luftführung durch das Modul befindet sich die Dichtgrenze für die IP-Schutzklasse nicht mehr plan an der Schrankwand, sondern zieht sich durch das Modul d.h. dass der Kühlkörper im Modul gegenüber dem restlichen Modul abgedichtet ist und der entsprechenden IP-Schutzklasse genügt.

Die mechanische Verriegelung des Moduls kann über einen werkzeuglosen Schnellverschluss erfolgen, der nicht nur den dichten Anschluss an den Frisch- und den Abluftkanal, sondern gleichzeitig auch die elektrische Kontaktierung des Moduls zur Versorgung, sowie weitere Anschlüsse wie z.B. Ballastwiderstände erledigt.

Durch diese effiziente Anordnung wird nicht nur der Tausch der Steuerung sehr einfach, schnell und ergonomisch angenehm, sondern es können auch sehr kompakte Steuerungseinschübe gebaut werden, von denen mehrere übereinander in einem skalierbaren Rack-basierten Schrank angeordnet werden können. Durch die geschickte Luftführung mit zwei unabhängigen vertikalen Luftkanälen in der Seitenwand bekommen auch die weiter oben verbauten Steuerungen kühle Frischluft und werden nicht von den unteren Steuerungen zusätzlich erhitzt. Dadurch sind die einzelnen Einschübe nahezu thermisch unabhängig voneinander.

Neben den Robotersteuerungen können die Fächer auch für andere Einschübe verwendet werden, beispielsweise in Form von Zusatzachsmodulen (also Frequenzumrichter ohne Steuerung), Einschubrahmen für Peripherie und Kundeneinbauten oder Kühlgerät für den Schrankinnenraum. Hierbei kühlt das Kühlgerät die Luft des Schrankinnenraumes und gibt die Abwärme, vergleichbar zu den Robotersteuerungen, an den seitlichen Luftkanal ab.

Kunden können Steuerungsmodule auch ohne Schrank erwerben und in eigene kundenspezifische Schränke verbauen. Hierbei können Module der vorgestellten Lösung verwendet werden und über Frisch- und Abluftrohre sehr flexibel in bestehende Kunden-Schrankkonzepte integriert werden.

Die Trennwand soll im Flächenbereich des angrenzenden ersten Schrankabteils jeweils in Höhe eines Schubfaches wenigstens eine separate erste Übertrittsöffnung aufweisen, die an ihrer dem jeweiligen Schubfach zuweisenden Seite einen ersten Dichtungsflansch aufweist, der ausgebildet ist, in einer im jeweiligen Schubfach eingesetzten und verriegelten Anordnung eines Einschub-Steuergerätes an einem korrespondierenden ersten Dichtungsgegenflansch einer Ansaugöffnung am Einschub-Steuergerätes luftdicht anzuliegen.

Die Trennwand soll im Flächenbereich des angrenzenden zweiten

Schrankabteils jeweils in Höhe eines Schubfaches wenigstens eine separate zweite Übertrittsöffnung aufweisen, die an ihrer dem jeweiligen Schubfach zuweisenden Seite einen zweiten Dichtungsflansch aufweist, der ausgebildet ist, in einer im jeweiligen Schubfach eingesetzten und verriegelten Anordnung eines Einschub-Steuergerätes an einem korrespondierenden zweiten Dichtungsgegenflansch einer Ausblasöffnung am Einschub-Steuergerätes luftdicht anzuliegen.

Der erste Dichtungsflansch, der erste Dichtungsgegenflansch, der zweite Dichtungsflansch und der zweite Dichtungsgegenflansch sollen jeweils mindestens eine Dichtungslippe aufweisen.

Innerhalb des zweiten Schrankabteils kann wenigstens ein Bremswiderstand angeordnet sein. Der eine Bremswiderstand oder die mehreren Bremswiderstände können dazu genutzt werden, die durch ein Verzögern der durch die Einschub-Steuergeräte angesteuerten Bewegung, beispielsweise eines Roboterarms, aufgrund des eintretenden Generatorbetriebs der elektrischen Motoren zurückgewonnene elektrische Energie in Wärme umzuwandeln.

An einer dem dritten Schrankabteil gegenüberliegenden Seite der Trennwand zwischen dem ersten Schrankabteil und dem zweiten Schrankabteil kann ein Kabelkanal ausgebildet sein, wobei die Trennwand im Flächenbereich dieses Kabelkanals elektrische Anschlussmittel aufweist, die ansteckseitig in Richtung des dritten Schrankabteils weisend angeordnet sind, so dass korrespondierende elektrische Gegenanschlussmittel eines im dritten Schrankabteil eingesetzten und verriegelten Einschub-Steuergerät mit den elektrischen Anschlussmitteln kontaktieren.

Jedes Schubfach des dritten Schrankabteils kann Schiebeführungen aufweisen, die ausgebildet sind, zum verschiebbaren Lagern eines in das jeweilige Schubfach eingesetzten Einschub-Steuergerätes zwischen einer Verriegelungsstellung, in der das Einschub-Steuergerät mechanisch, elektrisch und kühlluftströmungstechnisch an den Steuerschrank angeschlossen ist, und einer Entriegelungsstellung, in der das Einschub-Steuergerät mechanisch, elektrisch und kühlluftströmungstechnisch von dem Steuerschrank gelöst ist und aus dem Steuerschrank manuell herausgezogen werden kann.

Jedes Schubfach des dritten Schrankabteils kann einen manuell verstellbaren Verriegelungshebel aufweisen, der ausgebildet ist, ein im jeweiligen Schubfach gelagertes Einschub-Steuergerät wahlweise aus der Entriegelungsstellung in die Verriegelungsstellung und/oder aus der Verriegelungsstellung in die Entriegelungsstellung zu bewegen.

Die Aufgabe wird erfindungsgemäß außerdem gelöst durch ein Einschub-Steuergerät, das ausgebildet ist zum Einsetzen des Einschub-Steuergeräts in ein Schubfach des dritten Schrankabteils eines Steuerschranks nach einer oder mehreren der beschriebenen Ausführungen, wobei das Einschub-Steuergerät eine elektrische Antriebssteuerung eines Roboters, ein Zusatzachsen-Antriebsgerät, ein Kältegerät oder ein Peripherie-Einschubrahmen für Zusatzgeräte sein kann.

Das Einschub-Steuergerät kann ein Rastmittel aufweisen, das ausgebildet ist, in Zusammenwirken mit einem Verriegelungshebel des Steuerschrankes, eine Bewegung des Verriegelungshebels in eine Schubbewegung des Einschub-Steuergeräts innerhalb des Schubfaches zu übertragen, so dass durch Bewegen des Verriegelungshebels über das Rastmittel des Einschub-Steuergeräts das im jeweiligen Schubfach gelagerte Einschub-Steuergerät wahlweise aus der Entriegelungsstellung in die Verriegelungsstellung und/oder aus der Verriegelungsstellung in die Entriegelungsstellung bewegt wird.

Konkrete Ausführungsbeispiele der Erfindung sind in der nachfolgenden Beschreibung unter Bezugnahme auf die beigefügten Figuren näher erläutert. Konkrete Merkmale dieser exemplarischen Ausführungsbeispiele können unabhängig davon, in welchem konkreten Zusammenhang sie erwähnt sind, gegebenenfalls auch einzeln oder in weiteren Kombinationen betrachtet, allgemeine Merkmale der Erfindung darstellen.

Es zeigen:
- Fig. 1: eine perspektivische Darstellung einer beispielhaften ersten Ausführungsform eines erfindungsgemäßen Steuerschranks mit eingesetzten Einschub-Steuergeräten,
- Fig. 2: eine schematische Schnittdarstellung durch den Steuerschrank gemäß Fig. 1 und die Einschub-Steuergeräte gemäß Fig. 1,
- Fig. 3: eine perspektivische Darstellung einer abgewandelten zweiten Ausführungsform eines erfindungsgemäßen Steuerschranks mit eingesetzten Einschub-Steuergeräten,
- Fig. 4: eine schematische Schnittdarstellung durch den Steuerschrank gemäß Fig. 3 und die Einschub-Steuergeräte gemäß Fig. 3, und
- Fig. 5: eine vergrößerte perspektivische Darstellung eines einzelnen beispielhaften Einschub-Steuergeräts in einem Schubfach des Steuerschranks.

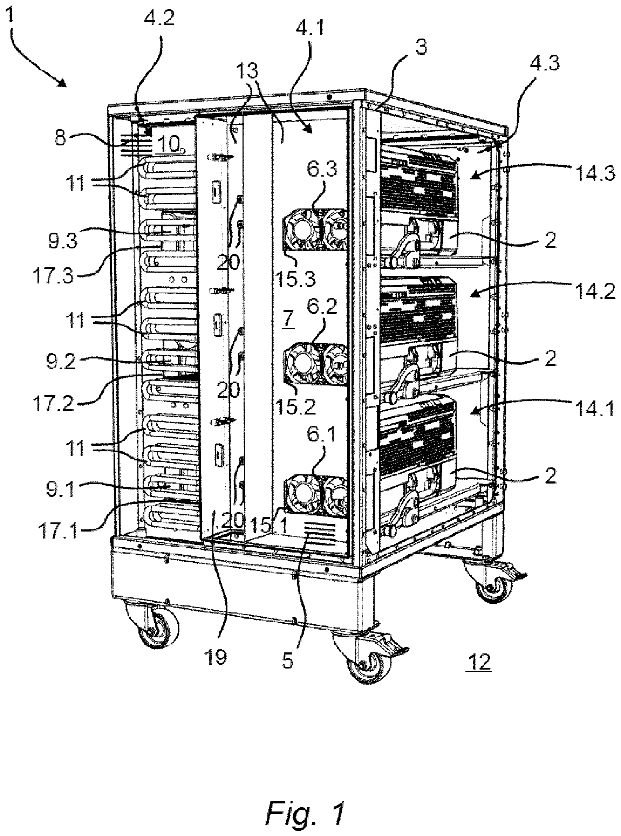

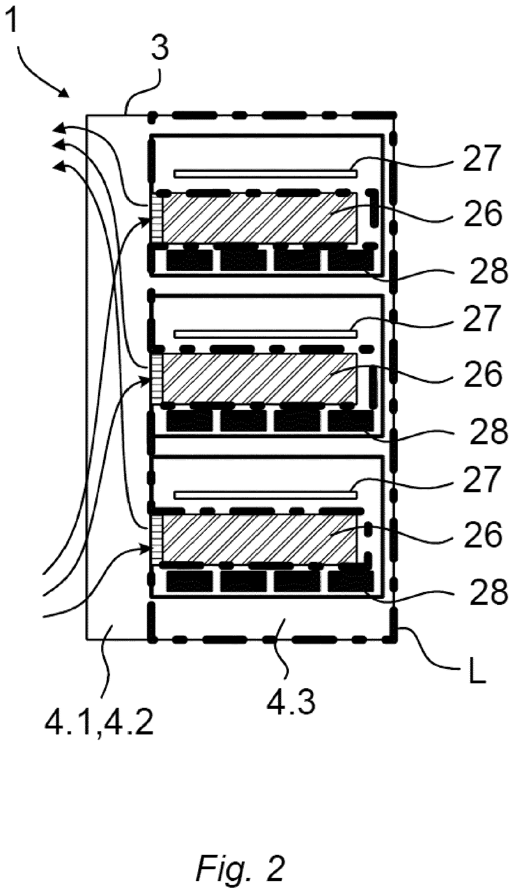

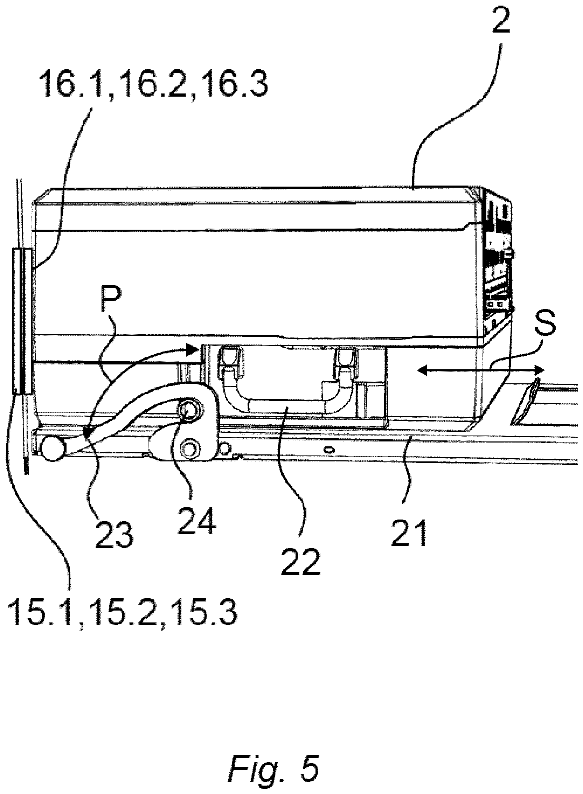

In der Fig. 1 und Fig. 2 ist eine beispielhafte erste Ausführungsform eines Steuerschranks 1 dargestellt. Der Steuerschrank 1 ist ausgebildet zur Aufnahme wenigstens einer elektrischen Antriebssteuerung 2, wie beispielsweise in Fig. 5 in Alleinstellung gezeigt ist.

Der Steuerschrank 1 weist ein Steuerschrankgehäuse 3 auf.

Im Steuerschrankgehäuse 3 ist ein erstes Schrankabteil 4.1 ausgebildet, das wenigstens eine Eintrittsöffnung 5 für Frischluft, wenigstens eine (im Falle des vorliegenden Ausführungsbeispiels genau drei) erste Übertrittsöffnung 6.1, 6.2, 6.3 und einen die wenigstens eine Eintrittsöffnung 5 mit der wenigstens einen ersten Übertrittsöffnung 6.1, 6.2, 6.3 strömungstechnisch verbindenden Frischluftkanal 7 aufweist. Die Eintrittsöffnung 5 ist in einer das erste Schrankabteil 4.1 verschließenden Abdeckungsblende integriert, die in Fig. 1 der Übersichtlichkeit halber abgenommen ist, jedoch die Lage der Eintrittsöffnung 5 durch horizontale Striche schematisch angedeutet sind, obwohl die Abdeckungsblende nicht gezeigt ist.

Im Steuerschrankgehäuse 3 ist des Weiteren ein zweites Schrankabteil 4.2 ausgebildetes, das wenigstens eine Austrittsöffnung 8 für Abluft, wenigstens eine (im Falle des vorliegenden Ausführungsbeispiels genau drei) zweite Übertrittsöffnung 9.1, 9.2, 9.3 und einen die wenigstens eine Austrittsöffnung 8 mit der wenigstens einen zweiten Übertrittsöffnung 9.1, 9.2, 9.3 strömungstechnisch verbindenden Abluftkanal 10 aufweist. Die Austrittsöffnung 8 ist in einer das zweite Schrankabteil 4.2 verschließenden Abdeckungsblende integriert, die in Fig. 1 der Übersichtlichkeit halber abgenommen ist, jedoch die Lage der Austrittsöffnung 8 durch horizontale Striche schematisch angedeutet sind, obwohl die Abdeckungsblende nicht gezeigt ist.

Innerhalb des zweiten Schrankabteils 4.2 sind im Falle des vorliegenden Ausführungsbeispiels mehrere Bremswiderstände 11 angeordnet.

Im Steuerschrankgehäuse 3 ist außerdem ein drittes Schrankabteil 4.3 ausgebildet, das strömungstechnisch sowohl gegen das erste Schrankabteil 4.1, das zweite Schrankabteil 4.2 und die Umgebung 12 außerhalb des Steuerschrankes 1 abgedichtet ist.

Das Steuerschrankgehäuse 3 weist darüber hinaus eine das dritte Schrankabteil 4.3 gegen das erste Schrankabteil 4.1 und das zweite Schrankabteil 4.2 strömungstechnisch abgrenzende Trennwand 13 auf, welche die ersten Übertrittsöffnungen 6.1, 6.2, 6.3 und die zweiten Übertrittsöffnungen 9.1, 9.2, 9.3 aufweist, wobei das dritte Schrankabteil 4.3 als ein Rack mit wenigstens einem Schubfach 14.1, 14.2, im Falle des vorliegenden Ausführungsbeispiels mit genau drei Schubfächern 14.1, 14.2, 14.3 ausgebildet ist, wobei jedes Schubfach 14.1, 14.2, 14.3 zur Aufnahme eines Einschub-Steuergerätes 2 ausgebildet ist.

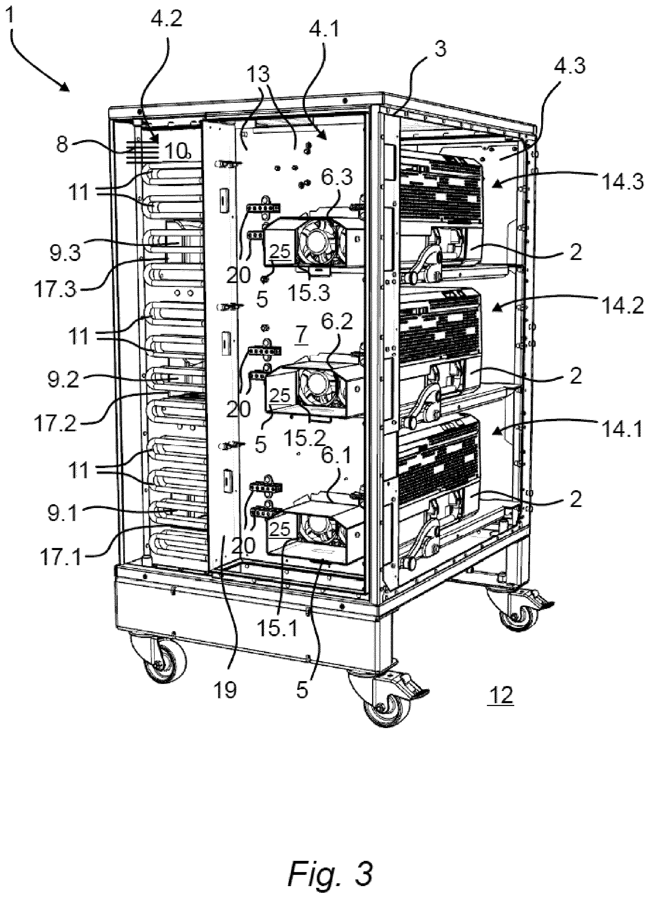

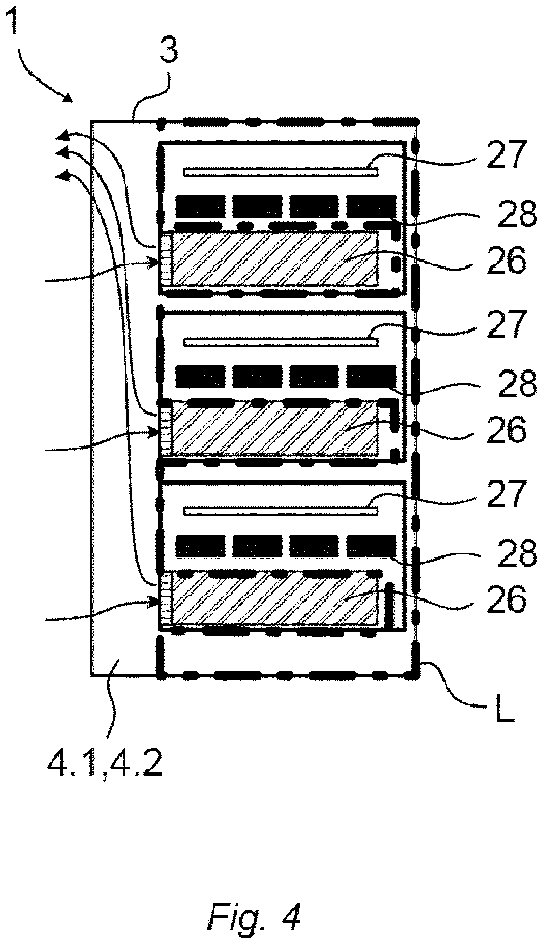

Sowohl in der ersten Ausführungsform gemäß Fig. 1 und Fig. 2, als auch in der zweiten Ausführungsform gemäß Fig. 3 und Fig. 4 weist die Trennwand 13 im Flächenbereich des angrenzenden ersten Schrankabteils 4.1 jeweils in Höhe eines Schubfaches 14.1, 14.2, 14.3 eine separate erste Übertrittsöffnung 6.1, 6.2, 6.3 auf, die an ihrer dem jeweiligen Schubfach 14.1, 14.2, 14.3 zuweisenden Seite einen ersten Dichtungsflansch 15.1, 15.2, 15.3 aufweist, der ausgebildet ist, in einer im jeweiligen Schubfach 14.1, 14.2, 14.3 eingesetzten und verriegelten Anordnung eines Einschub-Steuergerätes 2 an einem korrespondierenden ersten Dichtungsgegenflansch 16.1, 16.2, 16.3 einer Ansaugöffnung am Einschub-Steuergerätes 2 luftdicht anzuliegen.

Die zweite Ausführungsform gemäß Fig. 3 und Fig. 4 unterscheidet sich von der ersten Ausführungsform gemäß Fig. 1 und Fig. 2 u.a. dadurch, dass statt einer einzigen Eintrittsöffnung 5 (Fig. 1) gemäß der ersten Ausführungsform, welche die Frischluft in den Frischluftkanal 7 einlässt, so dass dort die Frischluft kaminartig auf die drei ersten Übertrittsöffnungen 6.1, 6.2, 6.3 verteilt wird, in der zweite Ausführungsform jeder der drei Übertrittsöffnungen 6.1, 6.2, 6.3 eine eigene separate Eintrittsöffnung 5 (Fig. 3) zugeordnet ist. Eine solche Zuordnung wird geschaffen durch jeweils einen Kanalstutzen 25, welcher die jeweilige Übertrittsöffnung 6.1, 6.2, 6.3 mit der eigenen separaten Eintrittsöffnung 5 (Fig. 3) verbindet.

In analoger Weise zu den ersten Übertrittsöffnung 6.1, 6.2, 6.3 des ersten Schrankabteils 4.1 weist die Trennwand 13 im Flächenbereich des angrenzenden zweiten Schrankabteils 4.2 jeweils in Höhe eines Schubfaches 14.1, 14.2, 14.3 eine separate zweite Übertrittsöffnung 9.1, 9.2, 9.3 auf, die an ihrer dem jeweiligen Schubfach 14.1, 14.2, 14.3 zuweisenden Seite einen zweiten Dichtungsflansch 17.1, 17.2, 17.3 aufweist, der ausgebildet ist, in einer im jeweiligen Schubfach 14.1, 14.2, 14.3 eingesetzten und verriegelten Anordnung eines Einschub-Steuergerätes 2 an einem korrespondierenden zweiten Dichtungsgegenflansch einer Ausblasöffnung am Einschub-Steuergerätes 2 luftdicht anzuliegen.

An einer dem dritten Schrankabteil 4.3 gegenüberliegenden Seite der Trennwand 13 zwischen dem ersten Schrankabteil 4.1 und dem zweiten Schrankabteil 4.2 ist im Falle der dargestellten Ausführungsbeispiele jeweils ein Kabelkanal 19 ausgebildet, wobei die Trennwand 13 im Flächenbereich dieses Kabelkanals 19 elektrische Anschlussmittel 20 aufweist, die ansteckseitig in Richtung des dritten Schrankabteils 4.3 weisend angeordnet sind, so dass korrespondierende elektrische Gegenanschlussmittel eines im dritten Schrankabteil 4.3 eingesetzten und verriegelten Einschub-Steuergerät 2 mit den elektrischen Anschlussmitteln 20 kontaktieren können. Der Kabelkanal 19 ist gegen die Außenluft abgedichtet, insbesondere an der Verbindung des Kanalstutzens 25 zur (nicht-sichtbaren) Seitenwand. Die Aufführung gemäß Fig. 3 ist vorteilhaft, da sie mehr Raum im Kabelkanal 19 und damit mehr Platz für zusätzliche Einbauten bietet.

Wie insbesondere in Fig. 5 ersichtlich ist, kann jedes Schubfach 14.1, 14.2, 14.3 des dritten Schrankabteils 4.3 Schiebeführungen 21 aufweisen, die ausgebildet sind, zum verschiebbaren Lagern eines in das jeweilige Schubfach 14.1, 14.2, 14.3 eingesetzten Einschub-Steuergerätes 2 zwischen einer Verriegelungsstellung (Fig. 5), in der das Einschub-Steuergerät 2 mechanisch, elektrisch und kühlluftströmungstechnisch an den Steuerschrank 1 angeschlossen ist, und einer Entriegelungsstellung, in der das Einschub-Steuergerät 2 mechanisch, elektrisch und kühlluftströmungstechnisch von dem Steuerschrank 1 gelöst ist und aus dem Steuerschrank 1 manuell herausgezogen werden kann. Zum manuellen Herausziehen, beispielsweise nach vorne, kann das Einschub-Steuergerät 2 einen Handgriff 22 aufweisen.

Wie in Fig. 5 dargestellt ist, kann jedes Schubfach 14.1, 14.2, 14.3 des dritten Schrankabteils 4.3 einen manuell verstellbaren Verriegelungshebel 23 aufweisen, der ausgebildet ist, ein im jeweiligen Schubfach 14.1, 14.2, 14.3 gelagertes Einschub-Steuergerät 2 wahlweise aus der Entriegelungsstellung in die Verriegelungsstellung (Fig. 5) und/oder aus der Verriegelungsstellung (Fig. 5) in die Entriegelungsstellung zu bewegen, wie dies durch die Pfeilrichtungen des Pfeils P angedeutet ist.

Das Einschub-Steuergerät 2 weist ein Rastmittel 24 auf, das ausgebildet ist, in Zusammenwirken mit dem Verriegelungshebel 23 des Steuerschrankes 1, eine Bewegung des Verriegelungshebels 23 in eine Schubbewegung S des Einschub-Steuergeräts 2 innerhalb des Schubfaches 14.1, 14.2, 14.3 zu übertragen, so dass durch Bewegen des Verriegelungshebels 23 über das Rastmittel 24 des Einschub-Steuergeräts 2 das im jeweiligen Schubfach 14.1, 14.2, 14.3 gelagerte Einschub-Steuergerät 2 wahlweise aus der Entriegelungsstellung in die Verriegelungsstellung (Fig. 5) und/oder aus der Verriegelungsstellung (Fig. 5) in die Entriegelungsstellung bewegt werden kann.

Die Fig. 2 und Fig. 4 zeigen jeweils schematisch durch eine fette gestrichelte Linie L die Grenze entlang der eine Abdichtung des dritten Schrankabteils 4.3 gegenüber dem ersten Schrankabteil 4.1 und dem zweiten Schrankabteil 4.2 erfolgt. Im Falle des ersten Ausführungsbeispiels sind die Kühlkörper 26 des jeweiligen Einschub-Steuergeräts 2 zwischen einer Steuerungsplatine 27 und den Leistungsbauteilen eines Frequenzumrichters 28 angeordnet. Ein Einschub-Steuergerät 2 gemäß der ersten Ausführungsform kann demgemäß analog einem Steuergerät wie in WO 2018/138041 A1 offenbart ausgebildet sein. Im Falle des zweiten Ausführungsbeispiels sind die Steuerungsplatine 27 und die Leistungsbauteile eines Frequenzumrichters 28 auf derselben Seite, d.h. unmittelbar benachbart zueinander angeordnet und die Kühlkörper 26 des jeweiligen Einschub-Steuergeräts 2 sind randseitig, d.h. neben den Leistungsbauteilen eines Frequenzumrichters 28 auf einer der Steuerungsplatine 27 gegenüberliegenden Seite angeordnet.

## Patentansprüche

1. Steuerschrank für wenigstens eine elektrische Antriebssteuerung (2), aufweisend:
ein Steuerschrankgehäuse (3),
ein im Steuerschrankgehäuse (3) ausgebildetes erstes Schrankabteil (4.1), das wenigstens eine Eintrittsöffnung (5) für Frischluft, wenigstens eine erste Übertrittsöffnung (6.1, 6.2, 6.3) und einen die wenigstens eine Eintrittsöffnung (5) mit der wenigstens einen ersten Übertrittsöffnung (6.1, 6.2, 6.3) strömungstechnisch verbindenden Frischluftkanal (7) aufweist,
ein im Steuerschrankgehäuse (3) ausgebildetes zweites Schrankabteil (4.2), das wenigstens eine Austrittsöffnung (8) für Abluft, wenigstens eine zweite Übertrittsöffnung (9.1, 9.2, 9.3) und einen die wenigstens eine Austrittsöffnung (8) mit der wenigstens einen zweiten Übertrittsöffnung (9.1, 9.2, 9.3) strömungstechnisch verbindenden Abluftkanal (10) aufweist, sowie
ein im Steuerschrankgehäuse (3) ausgebildetes drittes Schrankabteil (4.3), das strömungstechnisch sowohl gegen das erste Schrankabteil (4.1), das zweite Schrankabteil (4.2) und die Umgebung (12) außerhalb des Steuerschrankes (1) abgedichtet ist, wobei
das Steuerschrankgehäuse (3) eine das dritte Schrankabteil (4.3) gegen das erste Schrankabteil (4.1) und das zweite Schrankabteil (4.2) strömungstechnisch abgrenzende Trennwand (13) aufweist, welche die wenigstens eine erste Übertrittsöffnung (6.1, 6.2, 6.3) und die wenigstens eine zweite Übertrittsöffnung (9.1, 9.2, 9.3) aufweist, und das dritte Schrankabteil (4.3) als ein Rack mit wenigstens einem Schubfach (14.1, 14.2, 14.3) ausgebildet ist, wobei jedes Schubfach (14.1, 14.2, 14.3) zur Aufnahme eines Einschub-Steuergerätes (2) ausgebildet ist, wobei die Trennwand (13) im Flächenbereich des angrenzenden ersten Schrankabteils (4.1) jeweils in Höhe eines Schubfaches (14.1, 14.2, 14.3) wenigstens eine separate erste Übertrittsöffnung (6.1, 6.2, 6.3) aufweist, die an ihrer dem jeweiligen Schubfach (14.1, 14.2, 14.3) zuweisenden Seite einen ersten Dichtungsflansch (15.1, 15.2, 15.3) aufweist, der ausgebildet ist, in einer im jeweiligen Schubfach (14.1, 14.2, 14.3) eingesetzten und verriegelten Anordnung eines Einschub-Steuergerätes (2) an einem korrespondierenden ersten Dichtungsgegenflansch (16.1, 16.2, 16.3) einer Ansaugöffnung am Einschub-Steuergerätes (2) luftdicht anzuliegen und wobei die Trennwand (13) im Flächenbereich des angrenzenden zweiten Schrankabteils (4.2) jeweils in Höhe eines Schubfaches (14.1, 14.2, 14.3) wenigstens eine separate zweite Übertrittsöffnung (9.1, 9.2, 9.3) aufweist, die an ihrer dem jeweiligen Schubfach (14.1, 14.2, 14.3) zuweisenden Seite einen zweiten Dichtungsflansch (17.1, 17.2, 17.3) aufweist, der ausgebildet ist, in einer im jeweiligen Schubfach (14.1, 14.2, 14.3) eingesetzten und verriegelten Anordnung eines Einschub-Steuergerätes (2) an einem korrespondierenden zweiten Dichtungsgegenflansch einer Ausblasöffnung am Einschub-Steuergerätes (2) luftdicht anzuliegen, **dadurch gekennzeichnet, dass** der erste Dichtungsflansch (15.1, 15.2, 15.3), der erste Dichtungsgegenflansch (16.1, 16.2, 16.3), der zweite Dichtungsflansch (17.1, 17.2, 17.3) und der zweite Dichtungsgegenflansch eine Dichtungslippe aufweist.

2. Steuerschrank nach Anspruch 1 , **dadurch gekennzeichnet, dass** innerhalb des zweiten Schrankabteils (4.2) wenigstens ein Bremswiderstand (11) angeordnet ist.

3. Steuerschrank nach Anspruch 1 oder 2, **dadurch gekennzeichnet, dass** an einer dem dritten Schrankabteil (4.3) gegenüberliegenden Seite der Trennwand (13) zwischen dem ersten Schrankabteil (4.1) und dem zweiten Schrankabteil (4.2) ein Kabelkanal (19) ausgebildet ist, wobei die Trennwand (13) im Flächenbereich dieses Kabelkanals (19) elektrische Anschlussmittel (20) aufweist, die ansteckseitig in Richtung des dritten Schrankabteils (4.3) weisend angeordnet sind, so dass korrespondierende elektrische Gegenanschlussmittel eines im dritten Schrankabteil (4.3) eingesetzten und verriegelten Einschub-Steuergeräts (2) mit den elektrischen Anschlussmitteln (20) kontaktieren.

4. Steuerschrank nach einem der Ansprüche 1 bis 3, **dadurch gekennzeichnet, dass** jedes Schubfach (14.1, 14.2, 14.3) des dritten Schrankabteils (4.3) Schiebeführungen (21) aufweist, die ausgebildet sind, zum verschiebbaren Lagern eines in das jeweilige Schubfach (14.1, 14.2, 14.3) eingesetzten Einschub-Steuergerätes (2) zwischen einer Verriegelungsstellung, in der das Einschub-Steuergerät (2) mechanisch, elektrisch und kühlluftströmungstechnisch an den Steuerschrank (1) angeschlossen ist, und einer Entriegelungsstellung, in der das Einschub-Steuergerät (2) mechanisch, elektrisch und kühlluftströmungstechnisch von dem Steuerschrank (1) gelöst ist und aus dem Steuerschrank (1) manuell herausgezogen werden kann.

5. Steuerschrank nach Anspruch 4, **dadurch gekennzeichnet, dass** jedes Schubfach (14.1, 14.2, 14.3) des dritten Schrankabteils (4.3) einen manuell verstellbaren Verriegelungshebel (23) aufweist, der ausgebildet ist, ein im jeweiligen Schubfach (14.1, 14.2, 14.3) gelagertes Einschub-Steuergerät (2) wahlweise aus der Entriegelungsstellung in die Verriegelungsstellung und/oder aus der Verriegelungsstellung in die Entriegelungsstellung zu bewegen.

6. Einschub-Steuergerät, das ausgebildet ist zum Einsetzen des Einschub-Steuergeräts (2) in ein Schubfach (14.1, 14.2, 14.3) des dritten Schrankabteils (4.3) eines Steuerschranks (1) nach einem der Ansprüche 1 bis 5, **dadurch gekennzeichnet, dass** das Einschub-Steuergerät (2) eine elektrische Antriebssteuerung eines Roboters, ein Zusatzachsen-Antriebsgerät, ein Kältegerät oder ein Peripherie-Einschubrahmen für Zusatzgeräte ist.

7. Einschub-Steuergerät nach Anspruch 6, **dadurch gekennzeichnet, dass** das Einschub-Steuergerät (2) ein Rastmittel (24) aufweist, das ausgebildet ist, in Zusammenwirken mit einem Verriegelungshebel (23) des Steuerschrankes (1) nach Anspruch 8, eine Bewegung des Verriegelungshebels (23) in eine Schubbewegung (S) des Einschub-Steuergeräts (2) innerhalb des Schubfaches (14.1, 14.2, 14.3) zu übertragen, so dass durch Bewegen des Verriegelungshebels (23) über das Rastmittel (24) des Einschub-Steuergeräts (2) das im jeweiligen Schubfach (14.1, 14.2, 14.3) gelagerte Einschub-Steuergerät (2) wahlweise aus der Entriegelungsstellung in die Verriegelungsstellung und/oder aus der Verriegelungsstellung in die Entriegelungsstellung bewegt wird.

## Claims

1. Control cabinet for at least one electrical drive controller (2), having:
a control-cabinet housing (3),
a first cabinet section (4.1), which is formed in the control-cabinet housing (3) and has at least one entry opening (5) for fresh air, at least one first transfer opening (6.1, 6.2, 6.3) and also a fresh-air channel (7), which connects the at least one entry opening (5) in flow terms to the at least one first transfer opening (6.1, 6.2, 6.3),
a second cabinet section (4.2), which is formed in the control-cabinet housing (3) and has at least one exit opening (8) for waste air, at least one second transfer opening (9.1, 9.2, 9.3) and also a waste-air channel (10), which connects the at least one exit opening (8) in flow terms to the at least one second transfer opening (9.1, 9.2, 9.3), and
a third cabinet section (4.3), which is formed in the control-cabinet housing (3) and is sealed in flow terms in relation to the first cabinet section (4.1), the second cabinet section (4.2) and the surrounding area (12) outside the control cabinet (1), wherein
the control-cabinet housing (3) has a partition wall (13), which separates off the third cabinet section (4.3) in flow terms in relation to the first cabinet section (4.1) and the second cabinet section (4.2) and has the at least one first transfer opening (6.1, 6.2, 6.3) and the at least one second transfer opening (9.1, 9.2, 9.3), and the third cabinet section (4.3) is designed in the form of a rack with at least one drawer compartment (14.1, 14.2, 14.3), wherein each drawer compartment (14.1, 14.2, 14.3) is designed for receiving a push-in control unit (2), wherein, in the surface-area region of the adjacent first cabinet section (4.1), in each case at the level of a drawer compartment (14.1, 14.2, 14.3), the partition wall (13) has at least one separate first transfer opening (6.1, 6.2, 6.3), which, on its side facing the respective drawer compartment (14.1, 14.2, 14.3), has a first sealing flange (15.1, 15.2, 15.3), which is designed so that, in an arrangement in which a push-in control unit (2) has been inserted and locked in the respective drawer compartment (14.1, 14.2, 14.3), the first sealing flange butts in an air-tight manner against a corresponding first mating sealing flange (16.1, 16.2, 16.3) of an intake opening on the push-in control unit (2), and wherein, in the surface-area region of the adjacent second cabinet section (4.2), in each case at the level of a drawer compartment (14.1, 14.2, 14.3), the partition wall (13) has at least one separate second transfer opening (9.1, 9.2, 9.3), which, on its side facing the respective drawer compartment (14.1, 14.2, 14.3), has a second sealing flange (17.1, 17.2, 17.3), which is designed so that, in an arrangement in which a push-in control unit (2) has been inserted and locked in the respective drawer compartment (14.1, 14.2, 14.3), the second sealing flange butts in an air-tight manner against a corresponding second mating sealing flange of a blow-out opening on the push-in control unit (2), **characterized in that** the first sealing flange (15.1, 15.2, 15.3), the first mating sealing flange (16.1, 16.2, 16.3), the second sealing flange (17.1, 17.2, 17.3) and the second mating sealing flange each have a sealing lip.

2. Control cabinet according to Claim 1, **characterized in that** at least one braking resistor (11) is arranged within the second cabinet section (4.2).

3. Control cabinet according to Claim 1 or 2, **characterized in that** a cable duct (19) is formed between the first cabinet section (4.1) and the second cabinet section (4.2), on a side of the partition wall (13) that is located opposite the third cabinet section (4.3), wherein, in the surface-area region of this cable duct (19), the partition wall (13) has electrical connection means (20), the plug-in ends of which are arranged in the direction of the third cabinet section (4.3), so that corresponding mating electrical connection means of a push-in control unit (2) which has been inserted and locked in the third cabinet section (4.3) make contact with the electrical connection means (20).

4. Control cabinet according to one of Claims 1 to 3, **characterized in that** each drawer compartment (14.1, 14.2, 14.3) of the third cabinet section (4.3) has sliding guides (21), which are designed so that a push-in control unit (2) which has been inserted into the respective drawer compartment (14.1 14.2, 14.3) is thereby mounted for displacement between a locking position, in which the push-in control unit (2) has been connected to the control cabinet (1) mechanically, electrically and in terms of cooling-air flow, and an unlocking position, in which the push-in control unit (2) has been detached from the control cabinet (1) mechanically, electrically and in terms of cooling-air flow and can be pulled manually out of the control cabinet (1) .

5. Control cabinet according to Claim 4, **characterized in that** each drawer compartment (14.1, 14.2, 14.3) of the third cabinet section (4.3) has a manually adjustable locking lever (23), which is designed so that a push-in control unit (2) which has been mounted in the respective drawer compartment (14.1, 14.2, 14.3) is thereby moved optionally from the unlocking position into the locking position and/or from the locking position into the unlocking position.

6. Push-in control unit which is designed for insertion of the push-in control unit (2) into a drawer compartment (14.1, 14.2, 14.3) of the third cabinet section (4.3) of a control cabinet (1) according to one of Claims 1 to 5, **characterized in that** the push-in control unit (2) is an electrical drive controller of a robot, an additional-axis drive unit, a refrigeration unit or a push-in frame for peripherals for add-on units.

7. Push-in control unit according to Claim 6, **characterized in that** the push-in control unit (2) has a latching means (24) which is designed so that, interacting with a locking lever (23) of the control cabinet (1) according to Claim 8, a movement of the locking lever (23) is thereby converted into a pushing movement (S) of the push-in control unit (2) within the drawer compartment (14.1, 14.2, 14.3), so that, as a result of movement of the locking lever (23) via the latching means (24) of the push-in control unit (2), the push-in control unit (2) which has been mounted in the respective drawer compartment (14.1, 14.2, 14.3) is moved optionally from the unlocking position into the locking position and/or from the locking position into the unlocking position.

## Revendications

1. Armoire de commande pour au moins une commande d'entraînement électrique (2), présentant :
un boîtier d'armoire de commande (3),
un premier compartiment d'armoire (4.1) réalisé dans le boîtier d'armoire de commande (3) et qui présente au moins une ouverture d'entrée (5) pour de l'air frais, au moins une première ouverture de passage (6.1, 6.2, 6.3) et un conduit d'air frais (7) reliant en communication fluidique ladite au moins une ouverture d'entrée (5) à ladite au moins une ouverture de passage (6.1, 6.2, 6.3),
un deuxième compartiment d'armoire (4.2) réalisé dans le boîtier d'armoire de commande (3) et qui présente au moins une ouverture de sortie (8) pour de l'air vicié, au moins une deuxième ouverture de passage (9.1, 9.2, 9.3) et un conduit d'air vicié (10) reliant en communication fluidique ladite au moins une ouverture de sortie (8) à ladite au moins une deuxième ouverture de passage (9.1, 9.2, 9.3), et
un troisième compartiment d'armoire (4.3) réalisé dans le boîtier d'armoire de commande (3) et qui est rendu étanche en communication fluidique à la fois par rapport au premier compartiment d'armoire (4.1), au deuxième compartiment d'armoire (4.2) et à l'environnement (12) à l'extérieur de l'armoire de commande (1), dans laquelle
le boîtier d'armoire de commande (3) présente une cloison de séparation (13) délimitant en communication fluidique le troisième compartiment d'armoire (4.3) par rapport au premier compartiment d'armoire (4.1) et au deuxième compartiment d'armoire (4.2) et qui présente ladite au moins une première ouverture de passage (6.1, 6.2, 6.3) et ladite au moins une deuxième ouverture de passage (9.1, 9.2, 9.3), et le troisième compartiment d'armoire (4.3) est réalisé sous forme de rack avec au moins un tiroir (14.1, 14.2, 14.3), dans laquelle chaque tiroir (14.1, 14.2, 14.3) est réalisé pour recevoir un appareil de commande d'insertion (2), dans laquelle la cloison de séparation (13) présente dans la zone de surface du premier compartiment d'armoire (4.1) adjacent respectivement au niveau d'un tiroir (14.1, 14.2, 14.3) au moins une première ouverture de passage (6.1, 6.2, 6.3) séparée qui présente sur son côté tourné vers le tiroir (14.1, 14.2, 14.3) respectif une première bride d'étanchéité (15.1, 15.2, 15.3) qui est réalisée, lorsqu'un appareil de commande d'insertion (2) est agencé en étant inséré et verrouillé dans le tiroir (14.1, 14.2, 14.3) respectif, pour s'appliquer de manière étanche à l'air contre une première contre-bride d'étanchéité (16.1, 16.2, 16.3) correspondante d'une ouverture d'aspiration sur l'appareil de commande d'insertion (2), et dans laquelle la cloison de séparation (13) présente dans la zone de surface du deuxième compartiment d'armoire (4.2) adjacent respectivement au niveau d'un tiroir (14.1, 14.2, 14.3) au moins une deuxième ouverture de passage (9.1, 9.2, 9.3) séparée qui présente sur son côté tourné vers le tiroir (14.1, 14.2, 14.3) respectif une deuxième bride d'étanchéité (17.1, 17.2, 17.3) qui est réalisée, lorsqu'un appareil de commande d'insertion (2) est agencé en étant inséré et verrouillé dans le tiroir (14.1, 14.2, 14.3) respectif, pour s'appliquer de manière étanche à l'air contre une deuxième contre-bride d'étanchéité correspondante d'une ouverture d'évacuation sur l'appareil de commande d'insertion (2),
**caractérisée en ce que** la première bride d'étanchéité (15.1, 15.2, 15.3), la première contre-bride d'étanchéité (16.1, 16.2, 16.3), la deuxième bride d'étanchéité (17.1, 17.2, 17.3) et la deuxième contre-bride d'étanchéité présentent des lèvres d'étanchéité.

2. Armoire de commande selon la revendication 1, **caractérisée en ce qu'**au moins une résistance de freinage (11) est disposée à l'intérieur du deuxième compartiment d'armoire (4.2).

3. Armoire de commande selon la revendication 1 ou 2, **caractérisée en ce qu'**un chemin de câble (19) est réalisé sur un côté de la cloison de séparation (13), opposé au troisième compartiment d'armoire (4.3), entre le premier compartiment d'armoire (4.1) et le deuxième compartiment d'armoire (4.2), dans laquelle la cloison de séparation (13) présente dans la zone de surface de ce chemin de câble (19) des moyens de connexion électrique (20) qui sont disposés du côté enfichage en étant tournés en direction du troisième compartiment d'armoire (4.3) de sorte que des moyens de connexion électrique complémentaires correspondants d'un appareil de commande d'insertion (2) inséré et verrouillé dans le troisième compartiment d'armoire (4.3) entrent en contact avec les moyens de connexion électrique (20).

4. Armoire de commande selon l'une quelconque des revendications 1 à 3, **caractérisée en ce que** chaque tiroir (14.1, 14.2, 14.3) du troisième compartiment d'armoire (4.3) présente des glissières (21) qui sont réalisées pour le montage coulissant d'un appareil de commande d'insertion (2) inséré dans le tiroir (14.1, 14.2, 14.3) respectif entre une position de verrouillage dans laquelle l'appareil de commande d'insertion (2) est connectée à l'armoire de commande (1) de manière mécanique, électrique et en communication fluidique d'air de refroidissement, et une position de déverrouillage dans laquelle l'appareil de commande d'insertion (2) est détaché de l'armoire de commande (1) de manière mécanique, électrique et en communication fluidique d'air de refroidissement et peut être retiré manuellement de l'armoire de commande (1) .

5. Armoire de commande selon la revendication 4, **caractérisée en ce que** chaque tiroir (14.1, 14.2, 14.3) du troisième compartiment d'armoire (4.3) présente un levier de verrouillage (23) à réglage manuel qui est réalisé pour déplacer un appareil de commande d'insertion (2) logé dans le tiroir (14.1, 14.2, 14.3) respectif sélectivement de la position de déverrouillage à la position de verrouillage et/ou de la position de verrouillage à la position de déverrouillage.

6. Appareil de commande d'insertion qui est réalisé pour insérer l'appareil de commande d'insertion (2) dans un tiroir (14.1, 14.2, 14.3) du troisième compartiment d'armoire (4.3) d'une armoire de commande (1) selon l'une quelconque des revendications 1 à 5, **caractérisé en ce que** l'appareil de commande d'insertion (2) est une commande d'entraînement électrique d'un robot, un appareil d'entraînement d'axe auxiliaire, un appareil frigorifique ou un châssis d'insertion de périphérique pour des appareils auxiliaires.

7. Appareil de commande d'insertion selon la revendication 6, **caractérisé en ce que** l'appareil de commande d'insertion (2) présente un moyen d'arrêt (24) qui est réalisé pour convertir, en coopération avec un levier de verrouillage (23) de l'armoire de commande (1) selon la revendication 8, un mouvement du levier de verrouillage (23) en un mouvement de poussée (S) de l'appareil de commande d'insertion (2) à l'intérieur du tiroir (14.1, 14.2, 14.3) de sorte qu'un mouvement du levier de verrouillage (23) déplace par l'intermédiaire du moyen d'arrêt (24) de l'appareil de commande d'insertion (2) l'appareil de commande d'insertion (2) logé dans le tiroir (14.1, 14.2, 14.3) respectif sélectivement de la position de déverrouillage à la position de verrouillage et/ou de la position de verrouillage à la position de déverrouillage.
